# EUROPEAN PATENT APPLICATION

(11) **EP 4 694 591 A1**
(43) Date of publication of application: **11.02.2026**
(21) Application number: 24806071.7
(22) Date of filing: 15.01.2024
(51) Int. Cl.: H05K 5/00, F24F 1/22

(54) **ELECTRONIC CONTROL BOX, ELECTRONIC CONTROL DEVICE AND AIR CONDITIONER**

(30) Priority: 12.05.2023 CN 202321152534 U
(71) Applicant: GD Midea Heating & Ventilating Equipment Co., Ltd., Foshan, Guangdong 528311 (CN); Hefei Midea Heating & Ventilating Equipment Co., Ltd., Hefei, Anhui 230088 (CN)
(72) Inventor: TANG, Changqing, Foshan, Guangdong 528311 (CN); GU, Yong, Foshan, Guangdong 528311 (CN); ZHU, Menghao, Foshan, Guangdong 528311 (CN); QIN, Zhonghai, Foshan, Guangdong 528311 (CN); WANG, Xinli, Foshan, Guangdong 528311 (CN)
(74) Representative: RGTH
(86) International application number: PCT/CN2024/072327
(87) International publication number: WO 2024/234707

(57) **Abstract**

Provided are an electronic control box, an electronic control device, and an air conditioner. The electronic control box includes a box body (1), a box cover (2), and a mounting plate (4). The box body (1) includes a bottom plate (15) and an enclosing plate assembly arranged on the bottom plate (15). A cavity (16) is formed between the bottom plate (15) and the enclosing plate assembly and has an opening (161) opposite to the bottom plate (15). The enclosing plate assembly includes a first enclosing plate (11) and a second enclosing plate (12) that are opposite to each other in a first direction and a third enclosing plate (13) and a fourth enclosing plate (14) that are opposite to each other in a second direction. Each of the first direction and the second direction is perpendicular to a thickness direction of the bottom plate (15). The box cover (2) is L-shaped and includes a first cover plate (21) and a second cover plate (22) connected to the first cover plate (21). The box cover (2) is disposed at the box body (1). The second cover plate (22) covers the opening (161). The first cover plate (21) covers and is engaged with the first enclosing plate (11). The mounting plate (4) is located in the cavity (16) and disposed on the first enclosing plate (11).

## Description

### CROSS-REFERENCE TO RELATED APPLICATION

This application claims priority to Chinese Patent Application No. 2023211525347, filed on May 12, 2023, the entire contents of which are incorporated herein by reference.

### FIELD

The present disclosure relates to the field of air conditioner technologies, and more particularly, to an electronic control box, an electronic control device, and an air conditioner.

### BACKGROUND

Control components of an air conditioner are integrated and mounted in an electronic control box of the air conditioner. In the related art, the electronic control box offers unsatisfactory waterproof performance, and thus liquid water or water vapor from an external environment of the electronic control box enters an interior of the electronic control box, causing damage to components of the air conditioner.

### SUMMARY

The present disclosure aims to solve at least one of the technical problems in the related art to some extent.

To this end, an embodiment of the present disclosure provides an electronic control box, capable of adding a path for water to enter a cavity from a space above the cavity, improving waterproof performance, and enhancing convenience of fitting a mounting plate.

An embodiment of the present disclosure further provides an electronic control device.

An embodiment of the present disclosure further provides an air conditioner.

In a first aspect, the electronic control box according to an embodiment of the present disclosure comprises: a box body comprising a bottom plate and an enclosing plate assembly disposed at the bottom plate, a cavity being formed between the bottom plate and the enclosing plate assembly and having an opening opposite to the bottom plate, the enclosing plate assembly comprising a first enclosing plate and a second enclosing plate opposite to each other in a first direction, and a third enclosing plate and a fourth enclosing plate opposite to each other in a second direction, each of the first direction and the second direction being perpendicular to a thickness direction of the bottom plate; a box cover with an L-shape, comprising a first cover plate and a second cover plate connected to the first cover plate, the box cover being disposed at the box body, the second cover plate covering the opening, and the first cover plate covering the first enclosing plate and being engaged with the first enclosing plate; and a mounting plate located in the cavity and disposed at the first enclosing plate.

With the electronic control box according to the embodiment of the present disclosure, the obstruction for water to enter the cavity from an upper side of the cavity is increased, improving the waterproof performance of the electronic control box according to the embodiment of the present disclosure. Further, since the mounting plate is disposed on the first enclosing plate, the mounting plate can be directly disposed at the box body via the first enclosing plate, which eliminates a need to weld a mounting support for supporting the mounting plate within the cavity of the box body. In this way, a quantity of parts and the number of processing steps of the electronic control box are reduced, and the convenience of fitting the mounting plate is improved.

In some embodiments, the first enclosing plate is attached to the first cover plate.

In some embodiments, the first enclosing plate comprises: an attachment segment disposed at the bottom plate and attached to the first cover plate; and a support segment connected to the attachment segment and extending in a direction from the attachment segment toward the second enclosing plate, the support segment being detachably connected to the mounting plate.

In some embodiments, the mounting plate comprises: a plate body; and a first flange segment connected to the plate body. A part of the plate body is attached and connected to the support segment. The first flange segment faces away from the first enclosing plate and is attached to the first cover plate.

In some embodiments, the first enclosing plate further comprises a first connection segment. The first connection segment has an end connected to the attachment segment and another end connected to the support segment.

The mounting plate further comprises a second connection segment. The second connection segment has an end connected to the plate body and another end connected to the first flange segment. A recess is defined between the first connection segment and the second connection segment.

In some embodiments, the first connection segment is arc-shaped. The end of the first connection segment is tangent to the attachment segment, and the other end of the first connection segment being tangent to the support segment; and/or the second connection segment is arc-shaped, the end of the second connection segment being tangent to the plate body and the other end of the second connection segment being tangent to the first flange segment.

In some embodiments, a dimension of the attachment segment in the thickness direction of the bottom plate is smaller than a dimension of the second enclosing plate in the thickness direction of the bottom plate.

In some embodiments, the electronic control box further comprises: a support located in the cavity and disposed on at least one of the second enclosing plate and the bottom plate. The mounting plate has an end connected to the support segment and another end connected to the support.

In some embodiments, the electronic control box further comprises a threaded connection member. The one end of the mounting plate is connected to the support segment through the threaded connection member. The other end of the mounting plate is provided with a snap. The support has a snap-fit hole, the snap being engaged in the snap-fit hole.

In some embodiments, the support has a first end surface at a side of the support facing the mounting plate in the thickness direction of the bottom plate. The mounting plate comprises a plate body and a second flange segment connected to the plate body. The snap is disposed at the second flange segment, and the snap has a second end surface at a side of the snap facing the second cover plate in the thickness direction of the bottom plate. The second end surface comprises a first portion and a second portion; the first portion is closer to the second flange segment than the second portion in the first direction. The second portion abuts against the first end surface; and a distance between the first portion and the support segment in the thickness direction of the bottom plate is greater than a distance between the first end surface and the support segment in the thickness direction of the bottom plate.

In some embodiments, the mounting plate has a display hole formed on the mounting plate.

In some embodiments, the electronic control box further comprises a side mounting plate disposed at the bottom plate.

In some embodiments, an edge of the first cover plate at a side of the first cover plate facing away from the second cover plate in the thickness direction of the bottom plate is located, in the thickness direction of the bottom plate, between a side of the side mounting plate facing away from the bottom plate and a side of the first enclosing plate facing away from the second cover plate.

In some embodiments, a side of each of the first cover plate and the second cover plate in the second direction is provided with a first flange plate, the first flange plate being adjacent to the third enclosing plate. The other side of each of the first cover plate and the second cover plate in the second direction is provided with a second flange plate. The second flange plate is adjacent to the fourth enclosing plate.

In a second aspect, the electronic control device according to an embodiment of the present disclosure comprises: the electronic control box according to any one of the embodiments in the above first aspect; and an electrical component disposed in the cavity of the box body of the electronic control box.

With the electronic control device according to the embodiment of the present disclosure, the waterproof performance is improved, and the convenience of fitting the mounting plate is enhanced.

In some embodiments, the electronic control device further comprises a refrigerant pipeline and a display that are disposed in the cavity.

In some embodiments, a display hole is provided on the mounting plate of the electronic control box. Each of the refrigerant pipeline and the display is located between the mounting plate and the bottom plate of the box body. A display screen of the display faces the display hole; and the electrical component is located between the mounting plate and the second cover plate of the electronic control box.

In a third aspect, the air conditioner according to an embodiment of the present disclosure comprises the electronic control device according to any one of the embodiments in the above second aspect.

The air conditioner according to the embodiment of the present disclosure has advantages of satisfactory waterproof performance of the electronic control box and convenient fitting of the mounting plate.

### BRIEF DESCRIPTION OF THE DRAWINGS

FIG. 1 is a schematic structural view of an electronic control device according to an embodiment of the present disclosure.
FIG. 2 is a schematic structural view of a box body, a side mounting plate, a mounting plate, and a refrigerant pipeline according to an embodiment of the present disclosure.
FIG. 3 is a schematic structural view of a box body, a side mounting plate, a display, and a refrigerant pipeline according to an embodiment of the present disclosure.
FIG. 4 is a schematic cross-sectional structural view of an electronic control device according to an embodiment of the present disclosure.
FIG. 5 is an enlarged view of part A in FIG. 4.
FIG. 6 is an enlarged view of part B in FIG. 4.
FIG. 7 is a schematic structural view of a support and a snap according to an embodiment of the present disclosure.

Reference numerals of the accompanying drawings:
electronic control device 1000;
electronic control box 100, refrigerant pipeline 200, display 300, electrical component 400;
box body 1;
first enclosing plate 11, attachment segment 111, support segment 112, first connection segment 113, second enclosing plate 12, third enclosing plate 13, fourth enclosing plate 14, bottom plate 15, cavity 16, opening 161;
box cover 2, first cover plate 21, second cover plate 22, first flange plate 23;
side mounting plate 3;
mounting plate 4, plate body 41, first flange segment 42, second connection segment 43, second flange segment 44, snap 45, second end surface 451, first portion 4511, second portion 4512, first short side segment 452, second short side segment 453, long side segment 454, display hole 46;
support 5, first end surface 51, snap-fit hole 52, first transverse segment 53, first vertical segment 54, second transverse segment 55;
threaded connection member 6;
recess 7.

### DETAILED DESCRIPTION OF THE EMBODIMENTS

Embodiments of the present disclosure will be described in detail below with reference to examples thereof as illustrated in the accompanying drawings. The embodiments described below with reference to the drawings are illustrative only, and are intended to explain, rather than limit, the present disclosure.

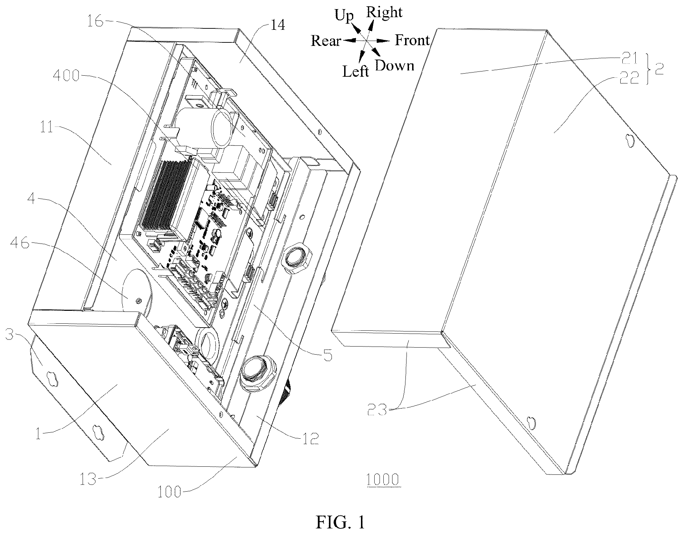

As illustrated in FIG. 1 to FIG. 7, an electronic control device 1000 according to an embodiment of the present disclosure comprises an electronic control box 100 and an electrical component 400.

The electronic control box 100 comprises a box body 1, a box cover 2, and a mounting plate 4. The box body 1 comprises a bottom plate 15 and an enclosing plate assembly disposed at the bottom plate 15. A cavity 16 is formed between the bottom plate 15 and the enclosing plate assembly and has an opening 161 opposite to the bottom plate 15. The enclosing plate assembly comprises a first enclosing plate 11 and a second enclosing plate 12 that are opposite to each other in a first direction (e.g., an up-down direction as illustrated in FIG. 1) and a third enclosing plate 13 and a fourth enclosing plate 14 that are opposite to each other in a second direction (e.g., a left-right direction as illustrated in FIG. 1). Each of the first direction and the second direction is perpendicular to a thickness direction of the bottom plate 15 (e.g., a front-rear direction as illustrated in FIG. 1). The box cover 2 is L-shaped and comprises a first cover plate 21 and a second cover plate 22 connected to each other. The box cover 2 is disposed at the box body 1. The second cover plate 22 covers the opening 161. The first cover plate 21 covers and is engaged with the first enclosing plate 11. The mounting plate 4 is located in the cavity 16 and disposed at the first enclosing plate 11.

The electrical component 400 is disposed in the cavity 16 of the box body 1 of the electronic control box 100.

In a use state of the electronic control device 1000 according to the embodiment of the present disclosure, the first enclosing plate 11 and the second enclosing plate 12 are opposite to each other in the up-down direction, with the first enclosing plate 11 located at an upper side of the second enclosing plate 1. The third enclosing plate 13 and the fourth enclosing plate 14 are opposite to each other in a horizontal direction. For example, the third enclosing plate 13 and the fourth enclosing plate 14 are opposite to each other in the left-right direction, with the third enclosing plate 13 located at a left side of the fourth enclosing plate 14, as illustrated in FIG. 1.

In the electronic control box 100 according to the embodiment of the present disclosure, the second cover plate 22 of the L-shaped box cover 2 covers the opening 161 of the cavity 16, and the first cover plate 21 of the L-shaped box cover 2 covers and is engaged with the first enclosing plate 11. In this way, the box cover 2 not only closes the opening 161 of the cavity 16 of the box body 1, but also forms a shield for an inner side (lower side) of the first cover plate 21 through an engagement between the first cover plate 21 and the first enclosing plate 11. Thus, water entering an interior of the cavity 16 from an upper side of the cavity 16 needs to pass through a gap between the first cover plate 21 and the first enclosing plate 11. A path for the water to enter the cavity 16 from a space above the cavity 16 is added through the engagement between the first enclosing plate 11 and the first cover plate 21, which increases the obstruction for water to enter the cavity 16 from the upper side of the cavity 16. In this way, waterproof performance of the electronic control box 100 according to the embodiment of the present disclosure is improved.

Further, the first enclosing plate 11 also serves to mount the mounting plate 4, enabling the mounting plate 4 to be disposed at the box body 1 via the first enclosing plate 11. The first enclosing plate 11 can replace a conventional frame for mounting the mounting plate 4, which is provided at a side where the first enclosing plate 11 is disposed, reducing a quantity of parts and processing steps of the electronic control box 100, and enhancing convenience of fitting the mounting plate 4.

Therefore, the electronic control box 100 according to the embodiment of the present disclosure achieves improved waterproof performance and enhanced convenience in fitting the mounting plate 4.

To make solutions of the present disclosure easier to understand, as an example, the first direction is described as the up-down direction, the second direction is described as the left-right direction, and the thickness direction of the bottom plate 15 is described as the front-rear direction. The up-down direction is illustrated in FIG. 1 to FIG. 7. The left-right direction is illustrated in FIG. 1 to FIG. 3 and FIG. 7. The front-rear direction is illustrated in FIG. 1 to FIG. 7.

The electronic control device 1000 according to an embodiment of the present disclosure comprises the electronic control box 100, the electrical component 400, a refrigerant pipeline 200, and a display 300.

The electronic control box 100 comprises a box body 1, a box cover 2, a mounting plate 4, a support 5, a threaded connection member 6, and a side mounting plate 3.

The box body 1 comprises the bottom plate 15 and the enclosing plate assembly disposed at the bottom plate 15. The cavity 16 is formed between the bottom plate 15 and the enclosing plate assembly and has the opening 161 opposite to the bottom plate 15. The enclosing plate assembly comprises the first enclosing plate 11 and the second enclosing plate 12 opposite to each other in the first direction, and the third enclosing plate 13 and the fourth enclosing plate 14 opposite to each other in the second direction.

The side mounting plate 3 is disposed at the bottom plate 15, facilitating mounting of the electronic control box 100 according to the embodiment of the present disclosure.

The box cover 2 is L-shaped and comprises the first cover plate 21 and the second cover plate 22 connected to the first cover plate 21. The box cover 2 is disposed at the box body 1. The second cover plate 22 covers the opening 161 of the cavity 16. The first cover plate 21 covers the first enclosing plate 11 and is engaged with the first enclosing plate 11. The box cover 2 covers the opening 161 of the cavity 16 of the box body 1 and the first enclosing plate 11 located at an upper part of the box body 1. In this way, the cavity 16 of the box body 1 is closed. Further, a path for the water to enter the cavity 16 from an upper side of the box body 1 is added through the engagement between the first enclosing plate 11 and the first cover plate 21.

Each of the first cover plate 21 and the second cover plate 22 is provided with a first flange plate 23 at a side (left side) of each of the first cover plate 21 and the second cover plate 22 in the second direction. The first flange plate 23 is adjacent to the third enclosing plate 13. Each of the first cover plate 21 and the second cover plate 22 is provided with a second flange plate (not illustrated in the figures) at the other side (right side) of each of the first cover plate 21 and the second cover plate 22 in the second direction. The second flange plate is adjacent to the fourth enclosing plate 14. In other words, the side and the other side of the first cover plate 21 are opposite to each other in the second direction, and the side and the other side of the second cover plate 22 are opposite to each other in the second direction. The side of the first cover plate 21 and the side of the second cover plate 22 are the same side in the second direction. The other side of the first cover plate 21 and the other side of the second cover plate 22 are the same side in the second direction.

The first flange plate 23 provides protection at the side of each of the first cover plate 21 and the second cover plate 22, preventing the water from entering the cavity 16 through a gap between the first cover plate 21 and the third enclosing plate 13 as well as a gap between the second cover plate 22 and the third enclosing plate 13. The second flange plate provides protection at the other side of each of the first cover plate 21 and the second cover plate 22, preventing the water from entering the cavity 16 through a gap between the first cover plate 21 and the fourth enclosing plate 14 as well as a gap between the second cover plate 22 and the fourth enclosing plate 14. Thus, the waterproof performance of the electronic control box 100 according to the embodiment of the present disclosure is further improved.

In some embodiments, the first enclosing plate 11 is attached to the first cover plate 21. A clearance between an upper side of the first enclosing plate 11 and an inner side of the first cover plate 21 that are attached to each other is narrow, and thus a gap between the upper side of the first enclosing plate 11 and the inner side of the first cover plate 21 is reduced, which increases sealing performance between the first enclosing plate 11 and the first cover plate 21. Consequently, the resistance and difficulty for the water to enter the cavity 16 through the gap between the first cover plate 21 and the first enclosing plate 11 are increased, further improving the waterproof performance of the electronic control box 100 according to the embodiment of the present disclosure.

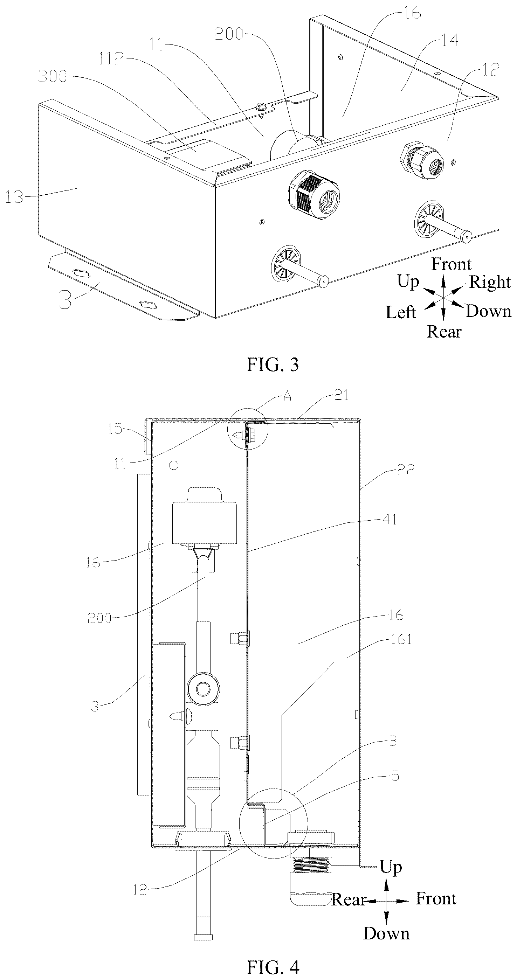

As illustrated in FIG. 4, an edge of the first cover plate 21 at a side (rear side), that faces away from the second cover plate 22 in the thickness direction of the bottom plate 15, of the first cover plate 21 is located between a side (rear side) of the side mounting plate 3 and a side (rear side) of the first enclosing plate 11 in the thickness direction of the bottom plate 15. The side of the side mounting plate 3 faces away from the bottom plate 15. The side of the first enclosing plate 11 faces away from the second cover plate 22. In this way, shielding effect of the first cover plate 21 for the first enclosing plate 11 is further enhanced, which further increases the obstruction for water to enter the cavity 16 from the upper side of the cavity 16. In this way, the waterproof performance of the electronic control box 100 according to the embodiment of the present disclosure is further improved without affecting the mounting of the electronic control box 100.

The first enclosing plate 11 comprises an attachment segment 111 and a support segment 112 connected to the attachment segment 111. The attachment segment 111 is disposed at the bottom plate 15 and attached to the first cover plate 21. The support segment 112 extends from the attachment segment 111 towards the second enclosing plate 12. That is, the attachment segment 111 is used to form the cavity 16. The mounting plate 4 is located in the cavity 16, and the support segment 112 is detachably connected to the mounting plate 4, facilitating mounting and removal of a mounting frame 4 and the box body 1. The mounting frame 4 is configured to divide the cavity 16 into two layers, allowing at least one of the electrical component 400, the refrigerant pipeline 200, and the display 300 to be mounted in a space within the cavity 16 between the mounting frame 4 and the second cover plate 22 or a space within the cavity 16 between the mounting frame 4 and the bottom plate 15. This layered configuration of the cavity 16 enhances a space utilization efficiency of the cavity 16, and facilitates an arrangement of the electrical component 400, the refrigerant pipeline 200, and the display 300 within the cavity 16.

In some embodiments, the mounting plate 4 comprises a plate body 41 and a first flange segment 42 connected to the plate body 41. A part of the plate body 41 is attached and connected to the support segment 112. The first flange segment 42 faces away from the first enclosing plate 11. That is, the first flange segment 42 extends towards the second cover plate 22. The first flange segment 42 is attached to the first cover plate 21, in such a manner that the water from the external environment can enter the cavity 16 only after passing through the gap between the first cover plate 21 and the first enclosing plate 11 and then through a clearance between the first cover plate 21 and the first flange segment 42. Additionally, since the part of the plate body 41 is attached and connected to the support segment 112, tight attachment between the part of the plate body 41 and the support segment 112 can prevent the water from flowing into the cavity 16 through any gap between the plate body 41 and the support segment 112. The path for the water to enter the cavity 16 from the space above the cavity 16 is further expanded through the attachment between the first flange segment 42 and the first cover plate 21, thereby further improving the waterproof performance of the electronic control box 100 according to the embodiment of the present disclosure.

In some embodiments, the first enclosing plate 11 further comprises a first connection segment 113. The first connection segment 113 has one end connected to the attachment segment 111 and another end connected to the support segment 112. The mounting plate 4 further comprises a second connection segment 43. The second connection segment 43 has one end connected to plate body 41 and another end connected to the first flange segment 42. A recess 7 is defined between the first connection segment 113 and the second connection segment 43. The recess 7 can store a predetermined amount of water, allowing the water flowing from the gap between the first cover plate 21 and the first enclosing plate 11 towards the first flange segment 42 to accumulate within the recess 7 when passing through the recess 7. In this way, the water is further obstructed from flowing into the cavity 16, and the waterproof performance of the electronic control box 100 is further improved.

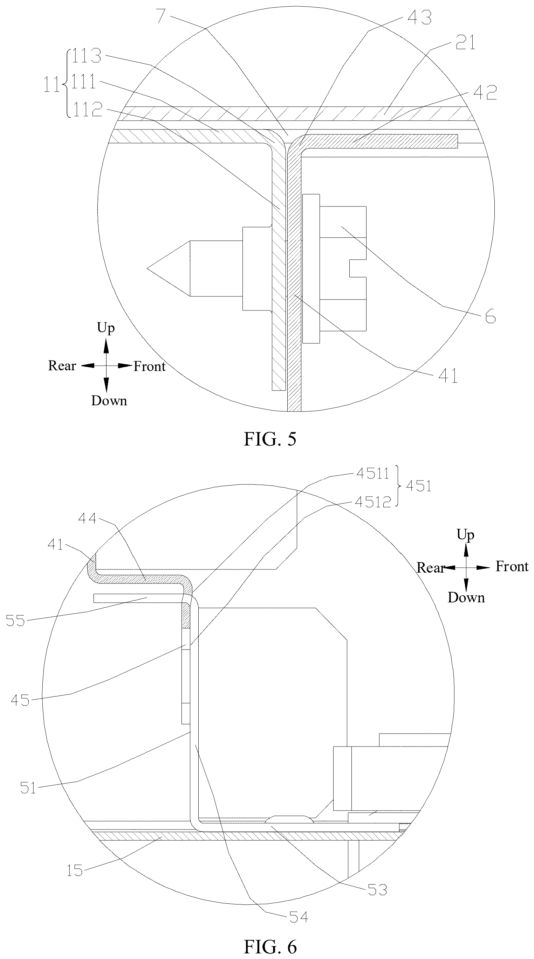

In some embodiments, as illustrated in FIG. 5, the first connection segment 113 is arc-shaped. The one end of the first connection segment 113 is tangent to the attachment segment 111. The another end of the first connection segment 113 is tangent to the support segment 112. The attachment segment 111, the first connection segment 113, and the support segment 112 can be formed through sheet metal stamping, which can reduce manufacturing costs of the first enclosing plate 11. The second connection segment 43 is arc-shaped. The one end of the second connection segment 43 is tangent to the plate body 41. The another end of the second connection segment 43 is tangent to the first flange segment 42. The plate body 41, the second connection segment 43, and the first flange segment 42 can be formed through sheet metal stamping, which can reduce manufacturing costs of the mounting plate 4.

The support 5 is located in the cavity 16 and disposed on at least one of the second enclosing plate 12 and the bottom plate 15. The mounting plate 4 has one end (an upper end) connected to the support segment 112 and another end (a lower end) connected to the support 5. Thus, mounting strength of the mounting plate 4 within the cavity 16 of the box body 1 is enhanced, improving stability of the mounting plate 4. Moreover, enabling the one end of the mounting plate 4 to be connected to the support segment 112 of the first enclosing plate 11 eliminates a need for a conventional frame used for mounting the mounting plate 4, in such a manner that only one support 5 needs to be disposed in the cavity 16 of the box body 1.

In some embodiments, the one end of the mounting plate 4 is connected to the support segment 112 through the threaded connection member 6. That is, the part of the plate body 41 is connected to the support segment 112 through the threaded connection member 6, ensuring tightness in a connection between the part of the plate body 41 and the support segment 112. The other end of the mounting plate 4 is provided with a snap 45. The support 5 has a snap-fit hole 52. The snap 45 is engaged in the snap-fit hole 52. When mounting the mounting plate 4 in the cavity 16, the snap 45 of the mounting plate 4 is engaged in the snap-fit hole 52, and then the part of the mounting plate 4 is fixed to the support segment 112 by using the threaded connection member 6. When removing the mounting plate 4 from the cavity 16, the threaded connection member 6 is removed to disengage the part of the mounting plate 4 from the support segment 112, and then the mounting plate 4 is moved to release the snap 45 from the snap-fit hole 52.

A connection between the other end of the mounting plate 4 and the support 5 realized through an engagement between the snap 45 and the snap-fit hole 52 is simple and detachable, which can further enhance convenience of fitting or detaching the mounting plate 4. Furthermore, maintenance of the electrical component 400, the refrigerant pipeline 200, and the display 300 is facilitated.

A dimension of the attachment segment 111 of the first enclosing plate 11 in the thickness direction of the bottom plate 15 is smaller than a dimension of the second enclosing plate 12 in the thickness direction of the bottom plate 15. That is, the attachment segment 111 has a height less than a height of the second enclosing plate 12, which allows the cavity 16 to have an opening opposite to the second enclosing plate 12. In this way, a size of the opening 161 of the cavity 16 is increased, and the opening 161 of the cavity 16 is provided to allow the number of opening directions to be increased. Thus, the convenience of assembly and disassembly between the mounting plate 4 and each of the support segment 112 and the support 5 is further improved.

In some embodiments, the support 5 has a first end surface 51 at a side of the support 5 facing the mounting plate 4 (i.e., a rear side of the support 5) in the thickness direction of the bottom plate 15. The mounting plate 4 further comprises a second flange segment 44 connected to the plate body 41. The second flange segment 44 and the first flange segment 42 are located at two sides of the plate body 41 in the first direction. The snap 45 is disposed at the second flange segment 44 and has a second end surface 451 at a side of the snap 45 facing the second cover plate 22 in the thickness direction of the bottom plate 15 (i.e., a front side of the snap 45). The second end surface 451 comprises a first portion 4511 and a second portion 4512. The first portion 4511 is closer to the second flange segment 44 than the second portion 4512 in the first direction. The second portion 4512 abuts against the first end surface 51. A distance between the first portion 4511 and the support segment 112 in the thickness direction of the bottom plate 15 is greater than a distance between the first end surface 51 and the support segment 112 in the thickness direction of the bottom plate 15. In other words, the first end surface 51 is located between the first portion 4511 and the second portion 4512 in the thickness direction of the bottom plate 15. That is, the second end surface 451 of the snap 45, when engaged in the snap-fit hole 52, is deformed under an interaction with the first end surface 51. The snap 45 is subjected to a force directed towards the support segment 112 in the thickness direction of the bottom plate 15. The force keeps the snap 45 and the mounting plate 4 in a tightened state, which prevents the snap 45 from wobbling. In this way, the stability of the mounting plate 4 is improved.

In other words, when the mounting plate 4 is not assembled onto the box body 1, a distance between a side surface of the support segment 112 that is attached to the part of the plate body 41 (i.e., a front side surface of the support segment 112) and the first end surface 51 in the thickness direction of the bottom plate 15 is A, and a distance between a side surface, that is attached to the support segment 112, of the part of the plate body 41 (i.e., a rear side surface of the part of the plate body 41) and the second end surface 451 in a thickness direction of the plate body 41 is B, where B is greater than A. When the mounting plate 4 is assembled onto the box body 1, the thickness direction of the plate body 41 is the same as the thickness direction of the bottom plate 15.

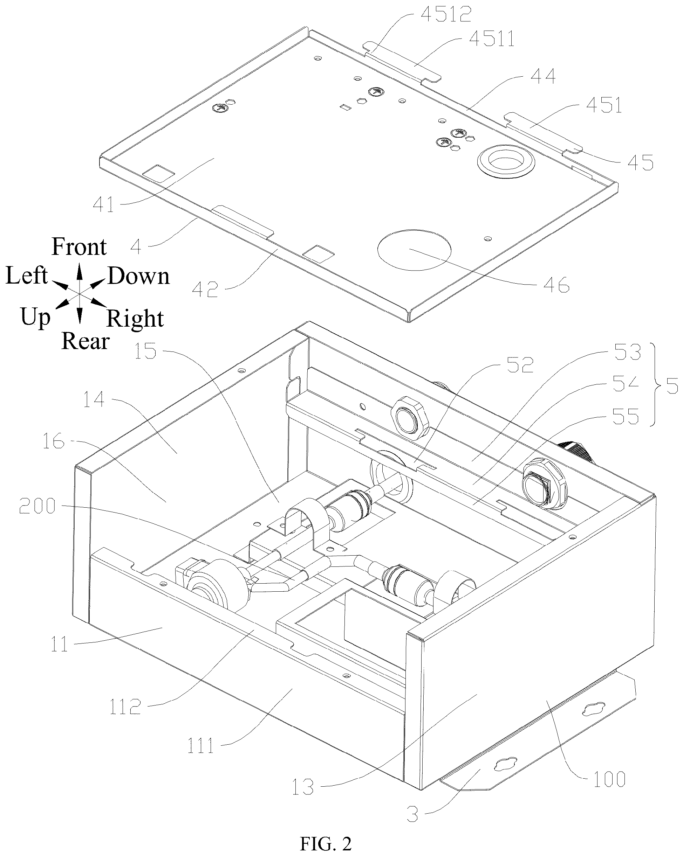

As illustrated in FIG. 2, FIG. 4, and FIG. 6, the support 5 is Z-shaped and comprises a first transverse segment 53, a first vertical segment 54, and a second transverse segment 55 that are sequentially connected to each other. The first transverse segment 53 is disposed at the second enclosing plate 12 and extends towards the second cover plate 22. The second transverse segment 55 extends towards the bottom plate 15. An end surface of the first vertical segment 54 at a side of the first vertical segment 54 facing the bottom plate 15 (i.e., a rear side of the first vertical segment 54) is formed as the first end surface 51. An interaction force between the first end surface 51 and the second end surface 451 enables the first end surface 51 to be subjected to a force directed towards the second cover plate 22, while the Z-shaped structure of the support 5 provides the support 5 a predetermined degree of support strength to ensure the fastening state and the stability of the mounting plate 4.

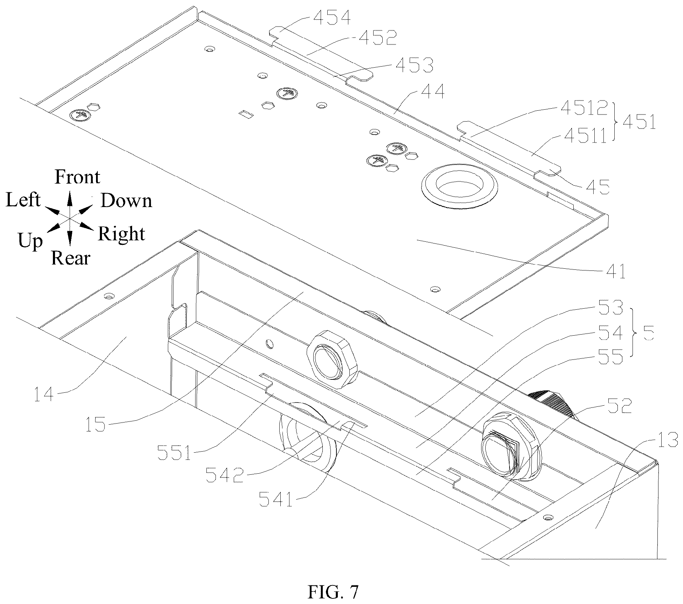

As illustrated in FIG. 7, the first vertical segment 54 has a T-shaped hole, which comprises an elongated hole 541 and a first short hole 542. The first short hole 542 is adjacent to the second transverse segment 55. The second transverse segment 55 has a second short hole 551 in communication with the first short hole 542. A dimension of the second short hole 551 in the second direction is the same as a dimension of the first short hole 542 in the second direction. The second short hole 551 and the first short hole 542 correspond to each other in the first direction. The snap-fit hole 52 is composed by the elongated hole 541, the first short hole 542, and the second short hole 551. The snap 45 comprises a long side segment 454, a first short side segment 452, and a second short side segment 453. The second short side segment 453 is connected to the second flange segment 44. A thickness direction of the second short side segment 453 is the same as a thickness direction of the second flange segment 44. The first short side segment 452 has an end connected to the second short side segment 453 and another end connected to the long side segment 454. end surfaces of the first short side segment 452 and the long side segment 454 at respective sides (front sides) of the first short side segment 452 and the long side segment 454 in respective thickness directions of the first short side segment 452 and the long side segment 454 are formed as the second end surface 451. In a process of engaging the snap 45 of the mounting plate 4 in the snap-fit hole 52, the long side segment 454 of the snap 45 is inserted into the elongated hole 541, and then the mounting plate 4 is rotated to enable each of the first short side segment 452 and the second short side segment 453 of the snap 45 to pass through the first short hole 542, in such a manner that the first short side segment 452 is engaged in the second short hole 551, and the second portion 4512 of the first end surface 451 abuts against the first end surface 51.

In some embodiments, the mounting plate 4 of the electronic control box 100 has a display hole 46. Each of the refrigerant pipeline 200 and the display 300 is located between the mounting plate 4 and the bottom plate 15 of the box body 1. A display screen of the display 300 faces the display hole 46, facilitating presentation of the display screen of the display 300 and reading of information displayed on the display 300 by a person. A layout in which the display 300 and the refrigerant pipeline 200 are arranged at the same layer is more rational, which can improve utilization of a space where the refrigerant pipeline 200 is located (i.e., a space between the mounting plate 4 and the bottom plate 15). The electrical component 400 is located between the mounting plate 4 and the second cover plate 22.

In some embodiments, the display 300 is disposed at the bottom plate 15, as illustrated in FIG. 3. In some embodiments, the display 300 may also be disposed at the plate body 41.

An air conditioner according to an embodiment of the present disclosure is described below.

The air conditioner according to the embodiment of the present disclosure comprises the electronic control device 100 according to any one of the above embodiments.

Therefore, the air conditioner of the present disclosure also has advantages of satisfactory waterproof performance of the electronic control box 100 and convenient fitting of the mounting plate 4.

In the description of the present disclosure, it should be understood that, the orientation or the position indicated by terms such as "center", "longitudinal", "transverse", "length", "width", "thickness", "over", "below", "front", "rear", "left", "right", "vertical", "horizontal", "top", "bottom", "inner", "outer", "clockwise", "anti-clockwise", "axial", "radial", and "circumferential" should be construed to refer to the orientation or the position as shown in the drawings, and is only for the convenience of describing the present disclosure and simplifying the description, rather than indicating or implying that the pointed device or element must have a specific orientation, or be constructed and operated in a specific orientation, and therefore cannot be understood as a limitation of the present disclosure.

In addition, the terms "first" and "second" are only used for descriptive purposes, and cannot be understood as indicating or implying relative importance or implicitly indicating the number of indicated technical features. Therefore, the features associated with "first" and "second" may explicitly or implicitly comprise at least one of the features. In the description of the present disclosure, "plurality" means at least two, such as two, three and so on, unless otherwise specifically defined.

In the present disclosure, unless otherwise clearly specified and limited, terms such as "install", "connect", "connect to", "fix" and the like should be understood in a broad sense. For example, it may be a fixed connection or a detachable connection or connection as one piece; mechanical connection, or electrical connection or mutual communication; direct connection or indirect connection through an intermediate; internal communication of two components or the interaction relationship between two components, unless otherwise clearly limited. For those of ordinary skill in the art, the specific meaning of the above-mentioned terms in the present disclosure can be understood according to specific circumstances.

In the present disclosure, unless expressly stipulated and defined otherwise, the first feature "on" or "under" the second feature may mean that the first feature is in direct contact with the second feature, or the first and second features are in indirect contact through an intermediate. Moreover, the first feature being "above" the second feature may mean that the first feature is directly above or obliquely above the second feature, or simply mean that the first feature is at a higher level than the second feature. The first feature being "below" the second feature may mean that the first feature is directly below or obliquely below the second feature, or simply mean that the first feature is at a lower level than the second feature.

Reference throughout this specification to "an embodiment", "some embodiments", "an example", "a specific example", or "some examples" means that a particular feature, structure, material, or characteristic described in connection with the embodiment or example is comprised in at least one embodiment or example of the present disclosure. The appearances of the above phrases in various places throughout this specification are not necessarily referring to the same embodiment or example. Further, the particular features, structures, materials, or characteristics may be combined in any suitable manner in one or more embodiments or examples. In addition, different embodiments or examples and features of different embodiments or examples described in the specification may be combined by those skilled in the art without mutual contradiction.

Although embodiments of the present disclosure have been shown and described above, it should be understood that the above embodiments are merely exemplary, and cannot be construed to limit the present disclosure. For those skilled in the art, changes, alternatives, and modifications can be made to the embodiments without departing from the scope of the present disclosure.

## Claims

1. An electronic control box, comprising:
a box body comprising a bottom plate (15) and an enclosing plate assembly disposed at the bottom plate (15), wherein a cavity (16) is formed between the bottom plate (15) and the enclosing plate assembly and has an opening (161) opposite to the bottom plate (15), and wherein the enclosing plate assembly comprises a first enclosing plate (11) and a second enclosing plate (12) opposite to each other in a first direction, and a third enclosing plate (13) and a fourth enclosing plate (14) opposite to each other in a second direction, wherein each of the first direction and the second direction is perpendicular to a thickness direction of the bottom plate (15);
a box cover (2) with an L-shape comprising a first cover plate (21) and a second cover plate (22) connected to each other, wherein the box cover (2) is disposed at the box body (1), wherein the second cover plate (22) covers the opening (161), and wherein the first cover plate (21) covers the first enclosing plate (11) and is engaged with the first enclosing plate (11); and
a mounting plate (4) located in the cavity (16) and disposed at the first enclosing plate (11).

2. The electronic control box according to claim 1, wherein the first enclosing plate (11) is attached to the first cover plate (21).

3. The electronic control box according to claim 2, wherein the first enclosing plate (11) comprises:
an attachment segment (111) disposed at the bottom plate (15) and attached to the first cover plate (21); and
a support segment (112) connected to the attachment segment (111) and extending in a direction from the attachment segment (111) toward the second enclosing plate (12), the support segment (112) being detachably connected to the mounting plate (4).

4. The electronic control box according to claim 3, wherein the mounting plate (4) comprises:
a plate body (41); and
a first flange segment (42) connected to the plate body (41), wherein a part of the plate body (41) is attached and connected to the support segment (112), and wherein the first flange segment (42) faces away from the first enclosing plate (11) and is attached to the first cover plate (21).

5. The electronic control box according to claim 4, wherein:
the first enclosing plate (11) further comprises a first connection segment (113), wherein the first connection segment (113) has an end connected to the attachment segment (111) and an other end connected to the support segment (112); and
the mounting plate (4) further comprises a second connection segment (43), wherein the second connection segment (43) has an end connected to the plate body (41) and an other end connected to the first flange segment (42), and wherein a recess (7) is defined between the first connection segment (113) and the second connection segment (43).

6. The electronic control box according to claim 5, wherein
the first connection segment (113) is arc-shaped, the end of the first connection segment (113) being tangent to the attachment segment (111), and the other end of the first connection segment (113) being tangent to the support segment (112); and/or
the second connection segment (43) is arc-shaped, the end of the second connection segment (43) being tangent to the plate body (41) and the other end of the second connection segment (43) being tangent to the first flange segment (42).

7. The electronic control box according to any one of claims 3 to 6, wherein a dimension of the attachment segment (111) in the thickness direction of the bottom plate (15) is smaller than a dimension of the second enclosing plate (12) in the thickness direction of the bottom plate (15).

8. The electronic control box according to any one of claims 3 to 7, further comprising:
a support (5) located in the cavity (16) and disposed on at least one of the second enclosing plate (12) and the bottom plate (15), wherein the mounting plate (4) has an end connected to the support segment (112) and an other end connected to the support (5).

9. The electronic control box according to claim 8, further comprising a threaded connection member (6), wherein:
the end of the mounting plate (4) is connected to the support segment (112) through the threaded connection member (6);
the other end of the mounting plate (4) is provided with a snap (45); and
the support (5) has a snap-fit hole (52), the snap (45) being engaged in the snap-fit hole (52).

10. The electronic control box according to claim 9, wherein:
the support (5) has a first end surface (51) at a side of the support (5) facing the mounting plate (4) in the thickness direction of the bottom plate (15);
the mounting plate (4) comprises a plate body (41) and a second flange segment (44) connected to the plate body (41); and
the snap (45) is disposed at the second flange segment (44), the snap (45) having a second end surface (451) at a side of the snap (45) facing the second cover plate (22) in the thickness direction of the bottom plate (15), and the second end surface (451) comprising a first portion (4511) and a second portion (4512), wherein:
the first portion (4511) is located closer to the second flange segment (44) than the second portion (4512) in the first direction;
the second portion (4512) abuts against the first end surface (51); and
a distance between the first portion (4511) and the support segment (112) in the thickness direction of the bottom plate (15) is greater than a distance between the first end surface (51) and the support segment (112) in the thickness direction of the bottom plate (15).

11. The electronic control box according to any one of claims 1 to 10, wherein a display hole (46) is formed on the mounting plate (4).

12. The electronic control box according to any one of claims 1 to 11, further comprising a side mounting plate (3) disposed at the bottom plate (15).

13. The electronic control box according to claim 12, wherein an edge of the first cover plate (21) at a side of the first cover plate (21) facing away from the second cover plate (22) in the thickness direction of the bottom plate (15) is located, in the thickness direction of the bottom plate (15), between a side of the side mounting plate (3) and a side of the first enclosing plate (11), wherein the side of the side mounting plate (3) faces away from the bottom plate (15) and the side of the first enclosing plate (11) faces away from the second cover plate (22).

14. The electronic control box according to any one of claims 1 to 13, wherein:
a side of each of the first cover plate (21) and the second cover plate (22) in the second direction is provided with a first flange plate (23) located adjacent to the third enclosing plate (13); and
an other side of each of the first cover plate (21) and the second cover plate (22) in the second direction is provided with a second flange plate located adjacent to the fourth enclosing plate (14).

15. An electronic control device, comprising:
an electronic control box (100) according to any one of claims 1 to 14; and
an electrical component (400) disposed in a cavity (16) of a box body (1) of the electronic control box (100).

16. The electronic control device according to claim 15, further comprising a refrigerant pipeline (200) and a display (300) that are disposed in the cavity (16).

17. The electronic control device according to claim 16, wherein:
a display hole (46) is formed on a mounting plate (4) of the electronic control box (100);
each of the refrigerant pipeline (200) and the display (300) is located between the mounting plate (4) and the bottom plate (15) of the box body (1);
a display screen of the display (300) faces the display hole (46); and
the electrical component (400) is located between the mounting plate (4) and the second cover plate (22) of the electronic control box (100).

18. An air conditioner, comprising an electronic control device according to any one of claims 15 to 17.
